# EUROPEAN PATENT APPLICATION

(11) **EP 4 102 942 A1**
(43) Date of publication of application: **14.12.2022**
(21) Application number: 21178415.2
(22) Date of filing: 09.06.2021
(51) Int. Cl.: H05K 3/30, H01G 2/06, H05K 7/12

(54) **BACKUP POWER MOUNTING STRUCTURE, ELECTRONIC CONTROL UNIT (ECU) AND METHOD FOR MANUFACTURING A BACKUP POWER MOUNTING STRUCTURE**

(71) Applicant: Veoneer Sweden AB, 447 37 Vårgårda (SE)
(72) Inventor: SAVIN, Anatolie, 700051 Iasi (RO); PADURARIU, Catalin, 700051 Iasi (RO)
(74) Representative: Reichert & Lindner Partnerschaft Patentanwälte

(57) **Abstract**

The invention relates to an electronic control unit (1) of a vehicle (16), comprising a backup power unit (7) and at least two flexible arms (11) arranged opposite to each other for fixing the backup power unit (7) to the backup power mounting structure (10) in a form and force fitting manner. At least two metal arms (12) are provided. One metal arm (12) is in a form fitting contact with a flat portion (13) of one flexible arm (11). Another metal arm (12) is in a form fitting contact with a flat portion (13) of another corresponding flexible arm (11). An electronic control unit (1) for a vehicle (16) comprises a closed housing (2) which is defined by a pot-like housing base (5) and a cover (4). Also provided is a method for manufacturing a backup power mounting structure (10) for an electronic control unit (1) of a vehicle (16).

## Description

### FIELD OF THE INVENTION

The invention relates to a backup power mounting structure. In particular, the invention relates to a backup power mounting structure, wherein the backup power mounting structure comprises a backup power unit and at least one pair of flexible arms arranged opposite to each other for fixing the backup power unit to the backup power mounting structure in a form and force fitting manner.

Additionally, the invention relates to an electronic control unit for a vehicle comprising a closed housing enclosing a backup power mounting structure.

Moreover the invention relates to a method for producing a backup power mounting structure for an electronic control unit of a vehicle.

### DESCRIPTION OF THE BACKGROUND ART

WO 2019/005616 A1 is directed to a surface mount coupling capacitor and a circuit board containing a surface mount coupling capacitor. The coupling capacitor includes a main body containing at least two sets of alternating dielectric layers and internal electrode layers. The coupling capacitor includes external terminals electrically connected to the internal electrode layers wherein the external terminals are formed on a top surface of the coupling capacitor and a bottom surface of the coupling capacitor opposing the top surface of the coupling capacitor.

WO 2010/059977 A2 discloses a solderless capacitor mount assembly including a cover having a base portion and a cover portion. The cover portion and base portion are couplable to each other so as to secure a capacitor to the cover. The assembly further includes at least one connector configured to couple the assembly to a printed circuit board, and at least one electrical contact configured to contact a respective at least one lead of the capacitor and provide an electrical connection for the capacitor.

US 2015/047887 A1 discloses a mounting circuit board of a multilayer ceramic capacitor. First and second internal electrodes are alternately exposed to both end surfaces of the ceramic body. The first and second external electrodes extend from both end surfaces of the ceramic body to a portion of a lower surface thereof. A printed circuit board has first and second electrode pads so that the first and second external electrodes are mounted thereon.

CN 207818380 U discloses an electrolytic capacitor mount.

CN 207282326 U relates to a specific super capacitor module group. A super capacitor module has a shell and an upper cover. The upper cover is connected to the shell, anode and cathode connection of the super capacitor module. The super capacitor module includes U shaped steel, circuit board and a plurality of super capacitors. The supercapacitor unit is fixed in on the circuit board and the circuit board is fixed in the recess of U-shaped steel.

As known, an electrical control unit (ECU) is an embedded electronic device, basically a digital computer, that controls one or more electrical systems or electrical sub systems of a vehicle based on, for example, information read from sensors placed at various parts and in different components of the vehicle. A typical ECU consists of a printed circuit board (PCB), a housing, a cover and, in some cases, a backup power unit. It must be ensured that the ECU is supplied with power even in cases where the main power unit has a malfunction. For this reason, the backup power unit is provided, which often is a relatively heavy capacitor. The capacitor is often fixed on the PCB or to a connector. The problem with fixing the backup power unit to the PCB is that the mass of the backup power unit is adding stress to the PCB, which might hurt the PCB. Fixing the power unit to the connector often causes undesired vibration noise. Therefore, most automotive engine control units (ECUs) are subjected to vibration tests. During the development process, the types of these tests are crucial for the selection of materials. Depending on the aggressiveness of the vibration tests, the materials chosen for the ECUs' housings can be either plastic or metal.

A typical ECU consists of a printed circuit board (PCB), a housing, a cover and, in some cases, a backup power unit. When using a backup power unit, the fixation solution of this part may affect the vibration performance of the entire ECU. Therefore, fixing the backup power unit is a major problem to be solved by the present invention.

Currently, there are mainly two types of housings for ECUs, i.e. plastic housings and metal housings.

In the case of plastic housings, the fixation of the backup power unit is realized via a plastic snap-fit solution, called "cradle", which is integrated into the plastic housing. The plastic snap-fit solution fails to retain the backup power unit after certain conditions are met, for example after the ECU's aging is finished and/or cheap plastic material is used.

In the other case of metal housings, the fixation of the backup power unit is also realized via a plastic snap-fit solution, but this time integrated into a different part of the ECU, for example in a plastic connector or in another part that is assembled into the housing. The integration of the cradle solution, i.e. the assembly and fixation into the housing, may be problematic because the fixation force of the power unit degrades over time. In addition, the plastic snap-fit solution fails to retain the backup power unit after certain conditions are met, for example after the ECU's aging is finished and/or cheap plastic material is used.

### SUMMARY OF THE INVENTION

It is an object of the present invention to provide a backup power mounting structure, which backup power mounting structure overcomes the problems of vibration, aging and material problems.

The above object is achieved by a backup power mounting structure for an electronic control unit of a vehicle according to claim 1.

It is a further object of the present invention to provide an electronic control unit for a vehicle, which electronic control unit overcomes the problems of vibration, aging and material problems.
The above object is achieved by an electronic control unit for an electronic control unit of a vehicle according to claim 8.

It is also an object of the present invention to provide a method for manufacturing a backup power mounting structure, which method overcomes the problems of vibration, aging and material problems.
The above object is achieved by an electronic control unit for an electronic control unit of a vehicle according to claim 11.

According to an embodiment, a backup power mounting structure, for example for an electronic control unit of a vehicle, comprises a backup power unit (backup power supply) and at least two flexible arms. The at least two flexible arms are arranged opposite to each other for fixing the backup power unit to the backup power mounting structure in a form and force fitting manner in the assembled state of backup power unit in backup power mounting structure. Preferably, at least two metal arms are also provided. In the assembled state of backup power unit in backup power mounting structure and metal arms at flexible arms, one metal arm of the at least two metal arms is in a form fitting contact with a flat portion of one flexible arm of the at least two flexible arms, and another metal arm of the at least two metal arms is in a form fitting contact with a flat portion of another corresponding flexible arm of the at least two flexible arms. The at least two metal arms back-up the at least two flexible arms.

In the construction principle described, the backup power mounting structure with its flexible arms receives the backup power unit. Then the fixation of the backup power unit is further improved, secured and vibration is reduced by the metal arms which are in form fitting contact with respective flat portions of the flexible arms . In addition, the metal arms provide greater stability to the entire backup power mounting structure, since the metal arms increase the retaining force of the flexible arms (plastic snaps) and maintain the same performances regardless of plastic used, even after the flexible (plastic) arms are aged.
Furthermore, a negative impact on other components of the ECU can be avoided, since the backup power unit is safely held in the backup power mounting structure and such a backup power mounting structure provides a strong, versatile and easy assembly solution for integrating it into metallic housings. In the other case of plastic housing integration, the metal part allows the plastic housing to be overmolded directly onto the metallic part. The same metallic part can be used for both plastic housing integration and metal housing integration.

In the following, more advantageous embodiments with improved stability and reduced vibrations are described.

In an embodiment, the backup power mounting structure is realized by a metallic part and a plastic portion or a separate plastic part. The metallic part has the at least two metal arms which are in a form fitting contact with the flat portion of each respective flexible arm of the plastic portion or separate plastic part in the assembled state of backup power unit in backup power mounting structure and metal arms at flexible arms.

In an embodiment, the backup power unit has a cylindrical form. A plurality of supports for the backup power unit are formed on the plastic portion or the separate plastic part. In the assembled state of backup power unit in backup power mounting structure, the backup power unit is in a form fitting contact with the supports.

In a particular embodiment, the backup power unit has a circumferential notch which cooperates with a rim on the plastic portion or the separate plastic part in a form fitting manner in the assembled state of backup power unit in backup power mounting structure. The rim is formed on the plastic portion or the separate plastic part and prevents movement of the backup power unit in its axial direction.

In an embodiment, the metallic part has the at least two metal arms and a plurality of assembly features. The assembly features are arranged in a plane of the metallic part. The metal arms are perpendicular to the plane. In particular, the plastic portion may be an integral part of a housing bottom of a housing base. The metallic part may be overmolded directly with the plastic material of the housing base. Alternatively, the metallic part may be overmolded with the separate plastic part, and the combined metallic part and the separate plastic part may be mounted to the housing bottom of the metal housing base with the assembly features of the metallic part.

An embodiment of the electronic control unit for a vehicle comprises a closed housing. The closed housing is defined by a pot-like housing base and a cover. The housing encloses a printed circuit board and a backup power mounting structure as described in any of the embodiments above.

In an embodiment, the housing base is made of metal. The housing base may have formed a plurality of housing pins each of which is in interference fit with a respective assembly feature of a metallic part. The overmolded separate plastic part defines the backup power mounting structure for the backup power unit.

In an alternative embodiment, the housing base is made of plastic. The housing base may have formed a plastic portion, which defines the backup power mounting structure and incorporates or has integrated a metallic part of the backup power mounting structure.

An embodiment of the method for manufacturing a backup power mounting structure for an electronic control unit of a vehicle as described in any of the embodiments above comprises the following steps: forming a metal part, so that at least two metal arms stretch out over a plane of the metal part and a plurality of assembly features are arranged within the plane; and overmolding the metal part with a plastic material, so that each of the at least two metal arms back one flexible arm of the backup power mounting structure in a form fitting contact. In the assembled state the backup power unit sits in backup power mounting structure and the flexible arms, backed by the metal arms, are in form fitting contact with the backup power unit.

In an embodiment, the overmolding forms at least a plurality of supports for the backup power unit.

In an embodiment, the overmolding forms a plastic portion which is an integral part of a housing bottom of a housing base. The metallic part becomes an integral part of the housing base by the overmolding with the plastic material.

In an embodiment, the overmolding forms a separate plastic part which is combined with the metallic part in the assembly process of producing the backup power mounting structure.

In an embodiment, the housing base is made of metal. The housing bottom of metal housing base has a plurality of housing pins. With an assembly tool, the housing pins of the housing bottom and the assembly features of the metallic part are brought into interference fit, so that the separate plastic part is combined with the metallic part and the housing bottom, or the combined metallic part and separate plastic part are mounted on the housing bottom.

### BRIEF DESCRIPTION OF THE DRAWINGS

The numerous advantages of the disclosure may be better understood by those skilled in the art by reference to the accompanying figures in which:
Figure 1 shows a schematic representation of the placement of an electronic control unit for a vehicle.
Figure 2 is a perspective and exploded view of an embodiment of a prior art electronic control unit for a vehicle.
Figure 3 is a partially cut away, perspective and exploded view of a prior art electronic control unit for a vehicle.
Figure 4 is a perspective view of a prior art backup power mounting structure with a mounted backup power unit.
Figure 5 is a perspective and exploded view of a backup power mounting structure according to an embodiment of the invention.
Figure 6 and 7 are perspective and partially cut away views of an embodiment of the housing base of an ECU, showing the formation of the backup power mounting structure on the housing bottom.
Figure 8 is a perspective and exploded view of an embodiment of the backup power mounting structure according to the embodiment of Figure 5.
Figure 9 is a perspective and exploded view showing the assembly of an ECU with the embodiment of backup power mounting structure as shown in Figure 8.
Figure 10 is a perspective, exploded and partially cut away view showing the mounting of the embodiment of the backup power mounting structure of Figure 5 or Figure 8 in a metallic housing base.
Figure 11 is a sectional view showing the cooperation of the housing pins with the assembly features of the backup power mounting structure.

### DETAILED DESCRIPTION

In the ensuing description, numerous specific details are provided to enable maximum understanding of the embodiments that are provided by way of example. The embodiments may be implemented with or without specific details, or else with other methods, components, materials, etc. In other circumstances, well-known structures, materials, or operations are not illustrated or described in detail so that various aspects of the embodiments will not be obscured. Reference in the course of the present description to "an embodiment" or "one embodiment" means that a particular structure, peculiarity, or characteristic described in connection with its implementation is comprised in at least one embodiment. Hence, phrases such as "in an embodiment" or "in one embodiment" that may recur in various points of the present description do not necessarily refer to one and the same embodiment. Furthermore, the particular structures, peculiarities, or characteristics may be combined in any convenient way in one or more embodiments.

Same reference numerals refer to same elements or elements of similar function throughout the various figures. Furthermore, only reference numerals necessary for the description of the respective figure are shown in the figures. The shown embodiments represent only examples of how the invention can be carried out. This should not be regarded as a limitation of the invention.

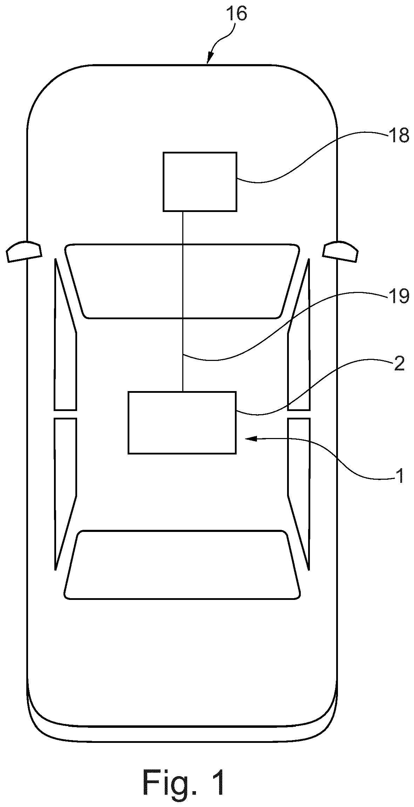

**Figure 1** shows a schematic representation of an embodiment of a placement of an electronic control unit (ECU) **1** for a vehicle **16.** Electronic control unit **1** controls one or more electrical systems of the vehicle **16** and is enclosed by a housing **2.** Housing **2** can be made of plastics or metallic materials. In cases where vibrations are more extreme during use of the vehicle **16,** housing **2** may be made of metallic materials, such as die-cast aluminium. To supply electrical power to the ECU **1,** ECU **1** is electrically connected to a vehicle battery **18** (main battery), typically by an electric line **19.**

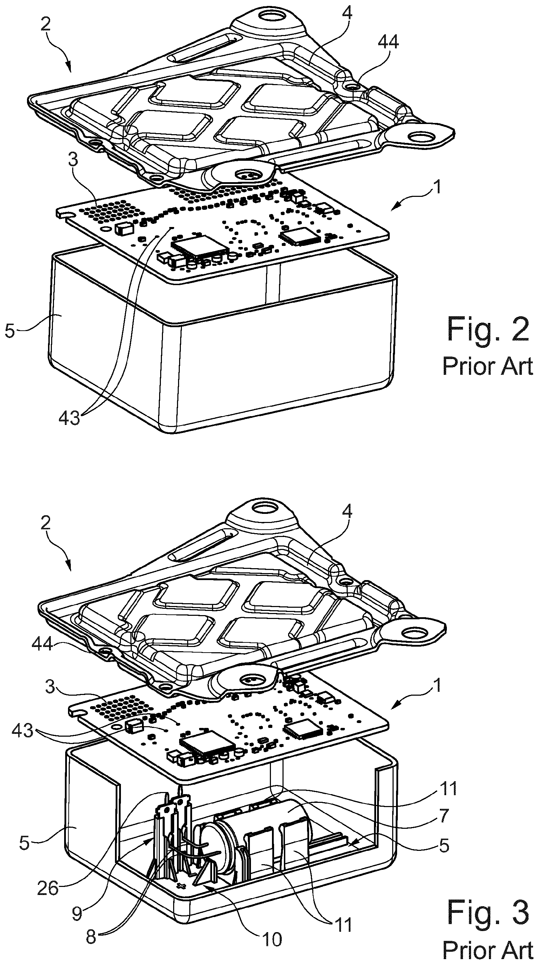

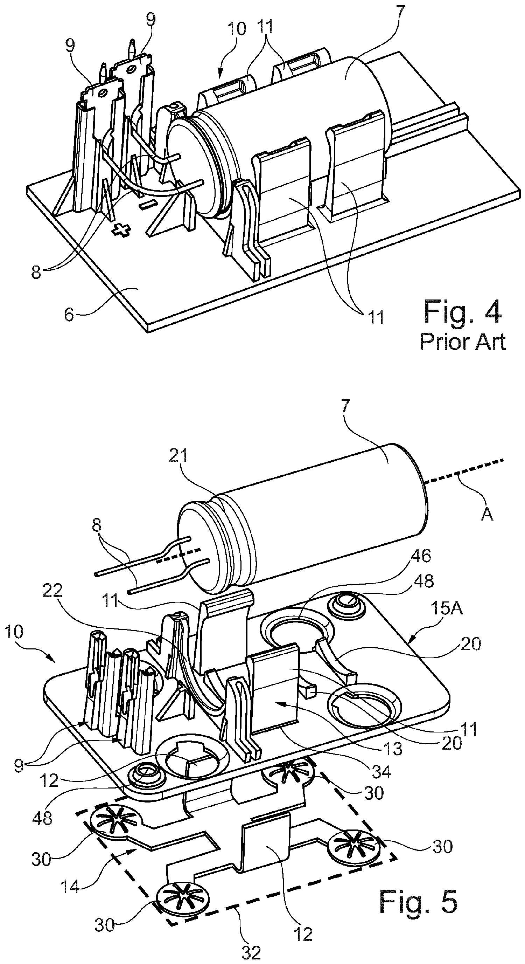

**Figure 2** is a perspective and exploded view of an embodiment of a prior art electronic control unit **1** for a vehicle **16,** for example like the one shown in Figure 1. **Figure 3** is a partially cut away, perspective and exploded view of a prior art electronic control unit **1** for a vehicle **16.** **Figure 4** is a perspective view of an embodiment of a prior art backup power mounting structure **10** with a mounted backup power unit **7,** for example like the one shown in Figure 3. ECU **1** is defined by a housing **2.** Housing **2** comprises a cover **4** and a housing base **5.** In cases where ECU **1** is subjected to stronger vibrations during the use of vehicle **16,** cover **4** and base **5** can be made of metallic materials such as die-cast aluminium.

To ensure that ECU **1** is supplied with power even in cases where the main vehicle battery **18** or the electric line **19** (see Figure 1) may have a malfunction, a backup power unit **7** is provided. Backup power unit **7** may be a capacitor having sufficient capacity to provide the necessary backup power. A backup power mounting structure **10** for carrying backup power unit **7** is arranged inside housing **2** and can be mounted directly to housing base **5.** Backup power unit **7** is fixed to backup power mounting structure **10** by at least one fixing means, for example by a cradle, for example a cradle with flexible arms **11.** Thus, backup power unit **7** is detachably attached on housing base **5.** In the embodiment of Figures 3 and 4, two flexible arms **11** are arranged on one side of backup power unit **7** and two further flexible arms **11** are arranged on the opposite side of backup power unit **7.** In total, therefore, four flexible arms **11** are shown in this embodiment. As mentioned above, such a backup power mounting structure **10** involves problems of vibration, aging of the plastic material and other material problems.

Furthermore, a printed circuit board **3** (PCB) is provided, which is placed inside the housing base **5,** which carries or defines the backup power mounting structure **10.** The housing base 5 is closed by cover **4.**

Cover **4,** printed circuit board **3,** backup power unit **7** and housing base **5** are connected, for example, with screws (not shown), thereby defining a sandwich structure. In order to establish the sandwich structure, cover **4,** printed circuit board **3** and housing base **5** have respective mounting openings or bores **44, 43, 46, 48.** At least some of the mounting openings or bores **44** of cover **4,** mounting openings or bores **43** of printed circuit board **3** and mounting openings or bores of housing base **5** are aligned with each other for being connected by corresponding pins or screws. At least one carrier arm **9** is provided on housing base **5** for supporting printed circuit board **3** and for fixing the electrical connections **8** of backup power unit **7.** As shown, each carrier arm **9** may hold an arm tip **26.** In the embodiment of Figures 3 and 4, the respective arm tip **26** of the two carrier arms **9** engage the respective mounting openings or bores **43** of printed circuit board **3.** An electrical connection **8** is provided from backup power unit **7** to printed circuit board **3,** for example by electric wires **8** leading from backup power unit **7** to printed circuit board **3** along or through the at least one carrier arm **9,** for example one electric wire **8** per carrier arm **9.**

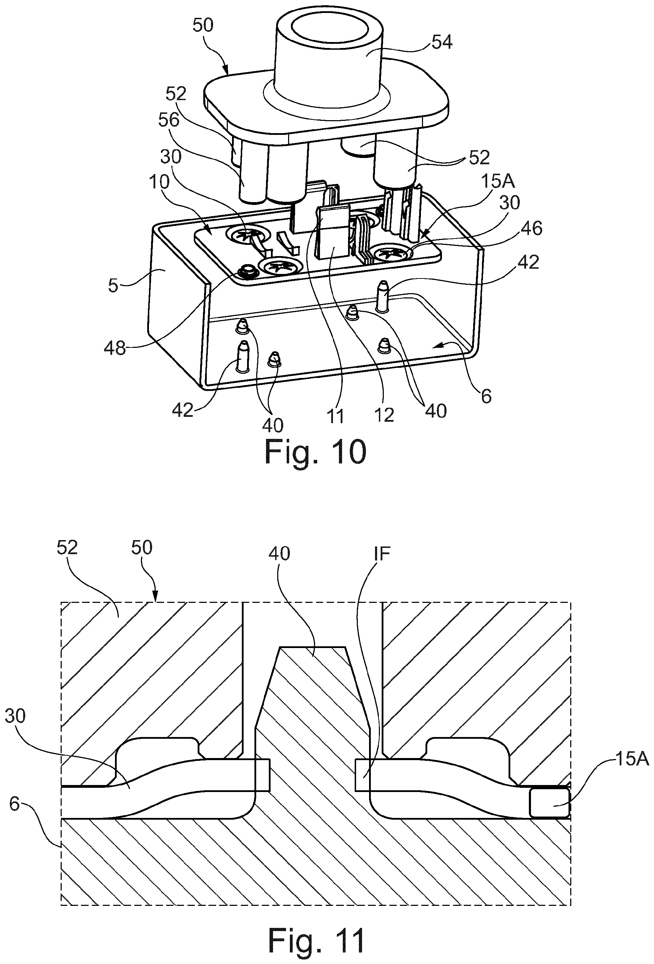

**Figure 5** is a perspective and exploded view of a backup power mounting structure **10** according to an embodiment of the invention. Backup power mounting structure **10** comprises a backup power unit **7** and at least two flexible arms **11** arranged opposite to each other for fixing backup power unit **7** to backup power mounting structure **10** in a form and force fitting manner. At least two metal arms **12** are provided. In the assembled state (see Figure 10), one metal arm **12** of the at least two metal arms **12** is in a form fitting contact with a flat portion **13** of one flexible arm **11** of the at least two flexible arms **11,** and another metal arm **12** of the at least two metal arms **12** is in a form fitting contact with a flat portion **13** of another corresponding flexible arm **11** of the at least two flexible arms **11.** Thus, the metal arms **12** back-up the flexible arms **11** of power mounting structure **10.** With the described construction principle, the backup power unit **10** can first be mounted to the ECU **1** and fixed with the flexible arms **11.** Then the fixation is further improved and secured and vibration is reduced by mounting the metal arms **12** to the respective flat portions **13** of the flexible arms **11** in a form fitting contact. In addition, the metal arms **12** provide greater stability to the entire backup power mounting structure **10.** Furthermore, a negative impact on other components of the ECU 1 can be avoided, since the backup power unit **7** is safely held in the backup power mounting structure **10.**

In the embodiment shown here, backup power mounting structure **10** may be realized by a metallic part **14** and a separate plastic part **15A.** Separate metallic part **14** is overmolded by separate plastic part **15A.** Metallic part **14** may have formed the at least two metal arms **12** which are in a form fitting contact with the flat portion **13** of each respective flexible arm **11** of the separate plastic part **15A** after the separate plastic part **15A** is overmolded to the separate metallic part **14.** Backup power unit **7** is fixed to backup power mounting structure **10.** The result of the overmolding is that the metal part **14** with its metal arms **12** is in contact with the respective flat portions **13** of the respective flexible arms **11.** Each metal arm **12** reaches through a corresponding slit **34,** formed during the overmolding process of the separate plastic part **15A,** and the metal arm **12** are in form fitting contact the respective flexible arms **11.**

Backup power unit **7** may be a capacitor having sufficient capacity to provide the necessary backup power. Backup power unit **7** may have a cylindrical form. A plurality of supports **20** for the backup power unit **7** may be formed on separate plastic part **15A.** In the assembled state, backup power unit **7** is in a form fitting contact with the supports **20** on separate plastic part **15A.**

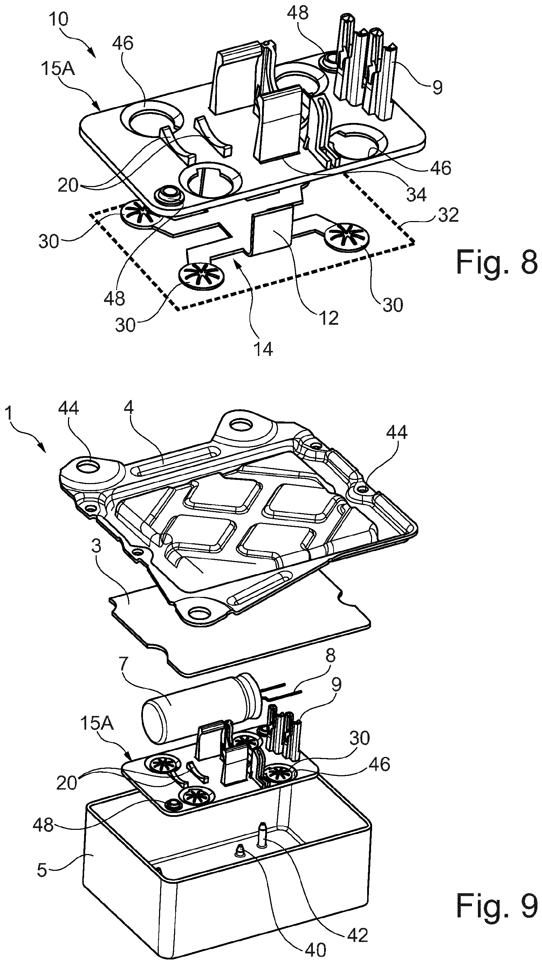

Analogous to Figures 3 and 4, also in Figure 5, an electrical connection **8** is provided from backup power unit **7** to printed circuit board **3** (see also Figure 9), for example by electric wires **8** leading from backup power unit **7** to printed circuit board **3** along or through the at least one carrier arm **9** (see Figure 9), for example one electric cable **8** per carrier arm **9.**

Backup power unit **7** may have a circumferential notch **21** which cooperates with a rim **22** in a form fitting manner after backup power unit **7** has been assembled into backup power mounting structure **10.** Rim **22** is formed on plastic portion **15** or separate plastic part **15A** and prevents movement of backup power unit **7** in its axial direction **A.**

Metallic part **14** may have the at least two metal arms **12** and a plurality of assembly features **30.** The assembly features **30** may be arranged in a plane **32** of metallic part **14** and the metal arms **12** may be perpendicular to plane **32** (see also Figures 8 and 10). As can be seen in Figure 10, in the assembled or overmolded state of metal part **14** with separate plastic part **15A,** each assembly feature **30** is visible through a corresponding mounting opening or mounting bore **46** within the plane of separate plastic part **15A.**

In contrary to Figures 3 and 4, in the embodiment of Figure 5, only one flexible arm **11** is arranged on one side of backup power unit **7** and only one further flexible arm **11** is arranged on the opposite side of backup power unit **7.** In total, therefore, only two flexible arms **11** are shown in this embodiment. Accordingly, only two metal arms **12** are provided in total, i.e. one metal arm **12** per each flexible arm **11.** Since metallic part **14** with metal arms **12** provides is high stability, also in comparison with flexible arms **11,** less flexible arms **11,** respectively less metal arms **12,** are required. For the skilled person in the art it is obvious that the number of flexible arms **11,** respectively also the number of metal arms **12,** is not meant to be construed in a limiting sense. Various numbers of flexible arms **11,** respectively numbers of metal arms **12,** are possible.

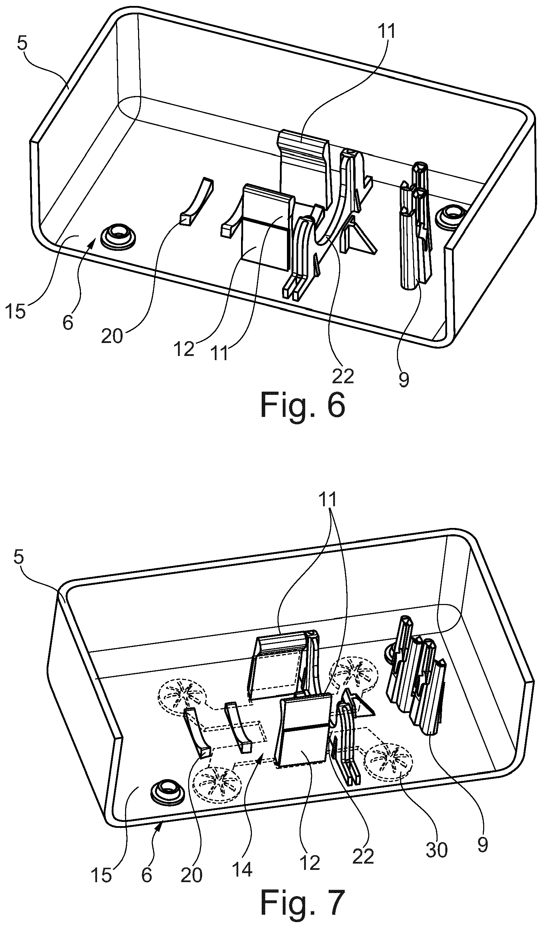

**Figure 6 and 7** are perspective and partially cut away views of an embodiment of housing base **5** of an ECU **1,** showing the formation of the backup power mounting structure **10,** for example like the one shown in Figure 5, on housing bottom **5.** Here, the plastic portion **15,** defining the backup power mounting structure **10** as an integral part of housing bottom **6.** In this embodiment, housing base **5** is made of plastic. During the process of forming the plastic housing base **5,** metallic part **14** is overmolded and forms an integral part of housing base **5.** Here the metal arms **12** reach up from the housing bottom **6** and are in a form fitting contact with the respective flexible arms **11.**

In the embodiment of Figure 6 and 7, the housing base **5** is made of plastic and the housing bottom **6** defines a plastic portion **15,** which defines the backup power mounting structure **10** after the overmolding process and incorporates the metallic part **14** of the backup power mounting structure **10.** In particular, plastic housing base **5** may be overmolded directly onto metallic part **14.** As described above, in the case of plastic housings, in particular plastic housing base **5,** the fixation with flexible arms **11** of backup power unit **7** may be realized via a plastic snap-fit solution, called "cradle", which is integrated into plastic housing base **5.**

**Figure 8** is a perspective and exploded view of an embodiment of a backup power mounting structure **10** according to the embodiment of the invention as shown in Figure 5. **Figure 9** is a perspective and exploded view showing the assembly of an ECU **1** with the embodiment backup power mounting structure **10** as shown in Figure 8. Analogous to Figures 3 and 4, cover **4,** printed circuit board **3,** backup power unit **7** and housing base **5** are to be mounted, for example with pins or screws (not shown), and define thereby a sandwich structure. In order to establish the sandwich structure, cover **4,** printed circuit board **3** and separate plastic part **15A** have mounting openings or bores **44, 43, 46, 48.** Some of the mounting openings or bores **44, 43, 48** of cover **4,** printed circuit board **3** and separate plastic part **15A** are aligned which each other and connected with each other, for example via pins or screws (not shown). At least one carrier arm **9** is arranged on separate plastic part **15A** for mounting printed circuit board **3.** In the embodiment of Figures 8 and 9, the respective upper ends of two carrier arms **9** engage or support the lower surface of printed circuit board **3.** An electrical connection **8** is provided from backup power unit **7** to printed circuit board **3,** for example by electric wires **8** leading from backup power unit **7** to printed circuit board **3** along or through the at least one carrier arm **9,** for example one electric cable **8** per carrier arm **9.**

ECU **1** for vehicle **16** may comprise a closed housing **2** which is defined by a pot-like housing base **5** and a cover **4,** wherein the housing **2** encloses printed circuit board **3** and backup power mounting structure **10.**

**Figure 10** is a perspective, exploded and partially cut away view showing the mounting of the embodiment of the backup power mounting structure **10** of Figure 5 or Figure 8 in a housing base **5.** **Figure 11** is a sectional view showing an embodiment of cooperation of the housing pins **40** with the assembly features **30** of the backup power mounting structure **10.** Housing base **5** is made of metal. Housing base **6** may have formed a plurality of housing pins **40** (see also Figure 9) each of which is in an interference fit **IF** with an assembly feature **30** of a metallic part **14,** in the assembled state. As mentioned above, metallic part **14** is overmolded with a separate plastic part **15A** and thereby forms the backup power mounting structure **10.**

Alternatively, the housing base **5** may be made of plastic and the housing base **6** defines a plastic portion **15** (see Figures 6 and 7), which defines the backup power mounting structure **10.** In the plastic portion **15** of housing base **6,** the metallic part **14** is incorporated by the overmolding process of metallic part **14.** Metallic part **14** being an integral part of plastic portion **15** defines the backup power mounting structure **10.** Also in this embodiment, the metal arms **12** back-up the flexible arms **11** of power mounting structure **10.** In particular, plastic housing base **5** may be overmolded directly onto metallic part **14.** As described above, in the case of plastic housings, in particular plastic housing base **5,** the fixation with flexible arms **11** of backup power unit **7** may be realized via a plastic snap-fit solution, called "cradle", which is integrated into plastic housing base **5.**

In an embodiment of the method for manufacturing a backup power mounting structure **10** for an electronic control unit **1,** for example of a vehicle **16,** according to the invention, a metal part **14** is formed, so that at least two metal arms **12** stretch out over a plane **32** of the metal part **14** and a plurality of assembly features **30** are arranged within the plane **32** (see Figure 5 and 8). The metal part **14** is then overmolded with a plastic material, so that each of the at least two metal arms **12** back one flexible arm **11** of the backup power mounting structure **10** in a form fitting contact. In a further embodiment of the method, the overmolding process forms at least a plurality of supports **20** (see Figures 5 to 9) for the backup power unit **7.** The overmolding may form a plastic portion **15** which is an integral part of a housing bottom **6** of a housing base **5** and the metallic part **14** may become an integral part of the housing base **5** by the overmolding with the plastic material.
An alternative production process is that a separate plastic part **15A** is combined with the metallic part **14** by the overmolding process, resulting in the backup power mounting structure **10.** A cradle, formed thereby, is provided for accommodating backup power unit **7** as described above, which is separately fixed on the housing bottom **6** of the metallic housing base **5.** The housing bottom **6** of metal housing base **5** may have a plurality of housing pins **40.** With an assembly tool **50** (see Figure 10), the housing pins **40** of housing bottom **6** may be brought into an interference fit **IF** with the corresponding assembly features **30** of metallic part **14,** so that separate plastic part **15A** combined with the metallic part **14** are mounted to the housing bottom **6.**

For carrying out the metallic housing integration, an assembly tool **50** may be used. By pushing leverage means **54** of assembly tool **50,** each lever bar **52** of assembly tool **50** is simultaneously pushed onto a corresponding assembly feature **30** of metallic part **14** and thereby said interference fit **IF** is created between assembly features **30** and corresponding housing pins **40.** Assembly features **30** and housing pins **40** may be made of metallic material or another solid material.

In a further embodiment, guiding pins **42** may be provided inside housing base **5.** For example, guiding pins **42** on housing bottom **6** in Figure 10 cooperate with mounting openings or mounting bores **48** in plastic part **15A.** In a further embodiment, at least one guiding bar **56** of assembly tool **50** cooperates with a mounting bore **48** in plastic part **15A.** The cooperation of the guiding pins **42,** mounting bores **48** and the guiding bars **56** allow a proper alignment and fixation of the backup power mounting structure **10** in the housing base **5.**

In summary, the present invention with the additional metal arms **12** can be used both for metal housings **4, 5** (as in separate plastic overmolded part) and plastic housings **4, 5** (as in housing overmolded over metallic part **14**). The invention can be used in multiple variants of ECUs **1** (RCS (Rich Communication Services), Vision, etc.). The metallic overmolded part **14** can be used as a standard part and have low complexity and are versatile, so that manufacturability of arms **12** is not difficult and expensive.

It is believed that the present disclosure and many of its attendant advantages will be understood by the foregoing description, and it will be apparent that various changes may be made in the form, construction and arrangement of the components without departing from the disclosed subject matter or without sacrificing all of its material advantages. The form described is merely explanatory, and it is the intention of the following claims to encompass and include such changes. Accordingly, the scope of the invention should be limited only by the claims appended hereto.

### LIST OF REFERENCE NUMERALS

- 1: Electronic control unit (ECU)
- 2: Housing
- 3: Printed circuit board
- 4: Cover
- 5: Housing base
- 6: Housing bottom
- 7: Backup power unit
- 8: Electrical connection, wire
- 9: Carrier arm
- 10: Backup power mounting structure
- 11: Flexible arm
- 12: Metal arm
- 13: Flat portion
- 14: Metallic part
- 15: Plastic portion
- 15A: Plastic part
- 16: Vehicle
- 18: Vehicle battery
- 19: Electric line
- 20: Support
- 21: Circumferential notch
- 22: Rim
- 26: Arm tip
- 30: Assembly feature
- 32: Plane
- 34: Slit
- 40: Housing pin
- 42: Guiding pin
- 43: Mounting opening, mounting bore in circuit board
- 44: Mounting opening, mounting bore in housing cover
- 46: Mounting opening, mounting bore for assembly feature
- 48: Mounting opening, mounting bore in plastic part
- 50: Assembly tool
- 52: Lever bar of assembly tool
- 54: Leverage means of assembly tool
- 56: Guiding bar
- A: Axial direction
- IF: Interference fit

## Claims

1. A backup power mounting structure (10), comprising
a backup power unit (7) and
at least two flexible arms (11) arranged opposite to each other for fixing the backup power unit (7) to the backup power mounting structure (10) in a form and force fitting manner in the assembled state of backup power unit (7) in backup power mounting structure (10),
**characterized by**
at least two metal arms (12), wherein one metal arm (12) of the at least two metal arms (12) is in a form fitting contact with a flat portion (13) of one flexible arm (11) of the at least two flexible arms (11), and another metal arm (12) of the at least two metal arms (12) is in a form fitting contact with a flat portion (13) of the other flexible arm (11) of the at least two flexible arms (11) in the assembled state of backup power unit (7) to back-up the flexible arms (11) of the power mounting structure (10).

2. The backup power mounting structure (10) according to claim 1, wherein the backup power mounting structure (10) is realized by a metallic part (14) and a plastic portion (15) or a separate plastic part (15A),
wherein the metallic part (14) has the at least two metal arms (12) which are in a form fitting contact with the flat portion (13) of each respective flexible arm (11) of the plastic portion (15) or separate plastic part (15A) in the assembled state.

3. The backup power mounting structure (10) according to claim 2,
wherein the backup power unit (7) has a cylindrical form,
a plurality of supports (20) for the backup power unit (7) are formed on the plastic portion (15) or the separate plastic part (15A), and in the assembled state, the backup power unit (7) is in a form fitting contact with the supports (20).

4. The backup power mounting structure (10) according to claim 3, wherein the backup power unit (7) has a circumferential notch (21) which cooperates with a rim (22) in a form fitting manner, wherein the rim (22) formed on the plastic portion (15) or the separate plastic part (15A) and prevents movement of the backup power unit (7) in its axial direction (A).

5. The backup power mounting structure (10) as claimed in any of the preceding claims, wherein the metallic part (14) has the at least two metal arms (12) and a plurality of assembly features (30), which are arranged in a plane (32) of the metallic part (14) and the metal arms (12) are perpendicular to the plane (32).

6. The backup power mounting structure (10) as claimed in claim 5, wherein the plastic portion (15) is an integral part of a housing bottom (6) of a housing base (5) and the metallic part (14) is overmolded directly with the plastic material of the housing base (5).

7. The backup power mounting structure (10) as claimed in claim 5, wherein the metallic part (14) is overmolded with the separate plastic part (15A) and the combined metallic part (14) and separate plastic part (15A) are mounted to the housing bottom (6) of the metal housing base (5) with the assembly features (30) of the metallic part (14).

8. An electronic control unit (1) for a vehicle (16) comprising a closed housing (2) which is defined by a pot-like housing base (5) and a cover (4), wherein the housing (2) encloses a printed circuit board (3) and a backup power mounting structure (10) as claimed in any of the preceding claims.

9. The electronic control unit (1) as claimed in claim 8, wherein the housing base (5) is made of metal and a housing base (6) has formed a plurality of housing pins (40) each of which is in an interference fit (IF) with an assembly feature (30) of a metallic part (14), overmolded with a separate plastic part (15A) of the backup power mounting structure (10).

10. The electronic control unit (1) as claimed in claim 8, wherein the housing base (5) is made of plastic and a housing base (6) has formed a plastic portion (15), which defines the backup power mounting structure (10) and incorporates an overmolded metallic part (14) of the backup power mounting structure (10).

11. A method for manufacturing a backup power mounting structure (10) for a backup power unit (7) according to any of claims 1 to 7,
**characterized by the steps of**
forming a metal part (14), so that at least two metal arms (12) stretch out over a plane (32) of the metal part (14) and a plurality of assembly features (30) are arranged within the plane (32); and
overmolding the metal part (14) with a plastic material, so that each of the at least two metal arms (12) back-up one flexible arm (11) of the backup power mounting structure (10) in a form fitting contact in the assembled state of backup power mounting structure (10).

12. The method as claimed in claim 11, wherein the overmolding forms at least a plurality of supports (20) for the backup power unit (7).

13. The method as claimed in any of the claims 11 to 12, wherein the overmolding forms a plastic portion (15) which is an integral part of a housing bottom (6) of a housing base (5) and the metallic part (14) becomes an integral part of the housing base (5) by the overmolding with the plastic material.

14. The method as claimed in any of the claims 11 to 12, wherein the overmolding forms a separate plastic part (15A) which is combined with the metallic part (14).

15. The method as claimed in claim 14, wherein the housing base (5) is made of metal, the housing bottom (6) of the metal housing base (5) has a plurality of housing pins (40), and with an assembly tool (50), the housing pins (40) of the housing bottom (6) and the assembly features (30) of the metallic part (14), combined with the separate plastic part (15A), are brought into an interference fit (IF), so that the combined metallic part (14) and separate plastic part (15A) are mounted on the housing bottom (6).
